# EUROPEAN PATENT APPLICATION

(11) **EP 0 655 779 A1**
(43) Date of publication of application: **31.05.1995**
(21) Application number: 94203167.5
(22) Date of filing: 31.10.1994
(51) Int. Cl.: H01L 21/60

(54) **Method of forming solder bumps on an integrated circuit flip chip**

(30) Priority: 26.11.1993 US 157511
(71) Applicant: DELCO ELECTRONICS CORPORATION, Kokomo Indiana 46902 (US)
(72) Inventor: Higdon, William David, Greentown, Indiana 46936 (US); Yeh, Shing, Buffalo Grove, Illinois 60089 (US); Cornell, Ralph Edward, Kokomo, Indiana 46902 (US); Blanton, James Arthur, Dunnellon, Florida 34432 (US)
(74) Representative: Denton, Michael John

(57) **Abstract**

A method of forming solder bumps (56) for use as terminals of an integrated circuit flip chip encompasses the use of a photoresist (52) which can be selectively patterned (54) with known photoengraving techniques, through which a preformulated solder composition can be accurately and selectively deposited on the surface (50) of the flip chip. A dry film photoresist (52) is used as a mask to apply a solder paste (56), such that precise registration, fine pitch bump arrays, and precise bump size control are possible. Precise control of the composition of the solder bumps (58) is also enabled, which relies on processing techniques which minimise processing costs. The process does not generate chlorofluorocarbons.

## Description

The present invention relates to a method of forming solder bumps on an integrated circuit flip chip for use, for example as terminals used to secure and electrically interconnect an integrated circuit chip to a circuit board, such as a ceramic substrate or printed wiring board.

Integrated circuit chips are typically soldered to conductor patterns on a circuit board, which may be a ceramic substrate or printed wiring board, in a manner which both secures and electrically interconnects the integrated circuit chip to the circuit board. Due to the numerous functions performed by integrated circuits, a relatively large number of terminals are required. Furthermore, because the size of typical integrated circuit chips is generally on the order of a few millimetres per side, the size and spacing of the terminals must be closely controlled in order properly to align and mount an integrated circuit chip to the corresponding conductor pattern formed on the circuit board.

A method which is widely practised for soldering integrated circuit chips to a substrate is the flip-chip bonding process. This process utilises an integrated circuit chip, or flip chip, which is generally a monolithic semiconductor device having bead-like terminals provided on one face of the chip. The terminals, or solder bumps, serve as connections between the integrated circuit chip and its corresponding conductor pattern. Flip chip conductor patterns are composed of numerous individual conductors, often as small as about 0.10 millimetres in width, and spaced as little as about 0.20 millimetres centre-to-centre. As a result, soldering an integrated circuit flip chip to its conductor pattern requires a significant degree of precision. The size and composition of the solder bumps must also be closely controlled to achieve the required reliability, bond integrity and electrical characteristics, while concurrently eliminating the potential for electrical shorting between adjacent solder bumps.

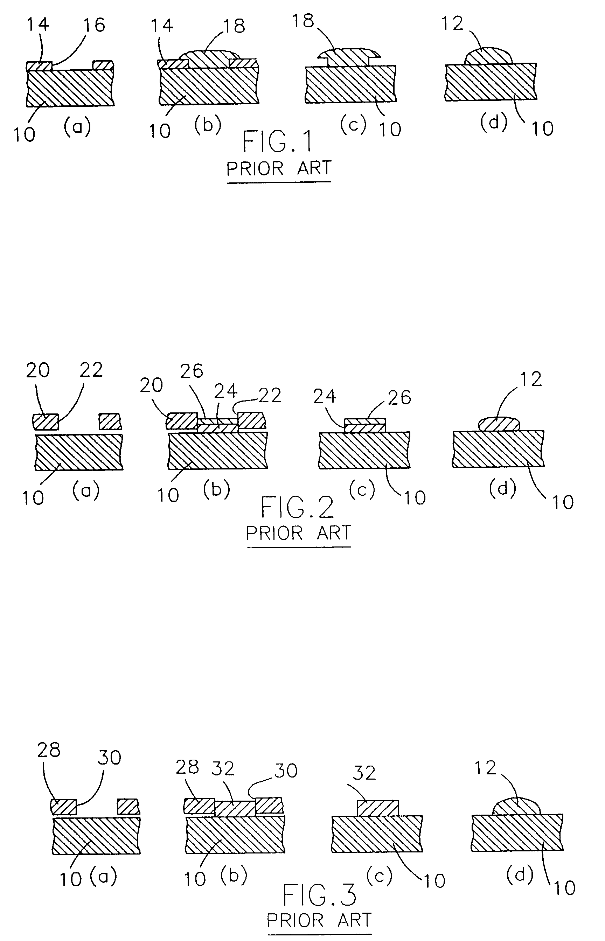

Various techniques have been employed to form solder bumps on flip chips, each of which having its own specific advantages. One such method is a plating process which involves the electrodeposition of a suitable solder composition on the flip chip. As illustrated in Figure 1, the steps typically involved to produce a solder bump 12 by this process include spinning a photoresist film 14 on a substrate 10 to a thickness of about 2 to about 25 micrometres. The photoresist film 14 is then photoengraved to form apertures, or vias 16 in the photoresist film 14 so as to expose a portion of the substrate 10, as shown in Step (a) of Figure 1. Using known photoengraving techniques, the achievable centre-to-centre spacing between adjacent vias 16 in the photoresist film 14 are on the order of about 0.20 millimetres. Solder 18 is then precipitated onto the substrate 10 in accordance with the electroplating process, the results of which are represented as Step (b). The photoresist 14 is then removed, as shown at (c), and the solder 18 is reflowed to form the solder bump 12, as shown at step (d).

A second method used to form solder bumps on a flip chip is an evaporation process illustrated in Figure 2. Such a process typically involves individually vaporising each metal required for the desired solder composition, and then allowing the vaporised metal to condense on a cooler substrate so as to form a layered film on the substrate, the aggregate of which has the desired solder composition. Shown as Step (a), a metal shadow mask 20 is made with vias 22 which correspond to where the solder bumps are intended to be formed on the substrate 10. The placement of the mask 20 over the substrate 10 is exaggerated and is not shown to be in direct contact with the substrate 10, so as to better show the disadvantages of using a mask 20 which does not directly adhere to the underlying substrate 10. As is apparent, the alignment of the mask 20 may vary with relation to the substrate 10, and also, there may be deposition of the evaporated metal under the mask 20 between the mask 20 and substrate 10 near the perimeter of the via 22. Once the mask 20 and substrate 10 are appropriately located within an evaporator, each metal constituent 24 and 26 of the desired solder composition is deposited in succession within a vacuum, as represented by Step (b) of Figure 2. The mask 20 is then removed, as shown at step (c), and the solder constituents 24 and 26 are reflowed to form the solder bump 12, as shown at step (d).

Another known method used to form solder bumps on a flip chip employs a stencil through which a solder paste is printed onto the substrate 10, as represented in Figure 3. As shown at Step (a) of Figure 3, a stencil 28 containing an appropriate number of vias 30 is first aligned with the substrate 10, typically with the use of a video camera. Similar to the mask 20 used in the evaporation process described above, the stencil 28 is not adhered to the surface of the substrate 10, in contrast to the plating technique illustrated in Figure 1. A solder paste 32 of the desired solder composition is then applied with a printer by pushing the paste 32 through the vias 30 in the stencil 28, the result of which is indicated by Step (b). The stencil 28 is then removed, as shown at step (c), and the solder paste 32 is reflowed to form the solder bump 12, as shown at step (d).

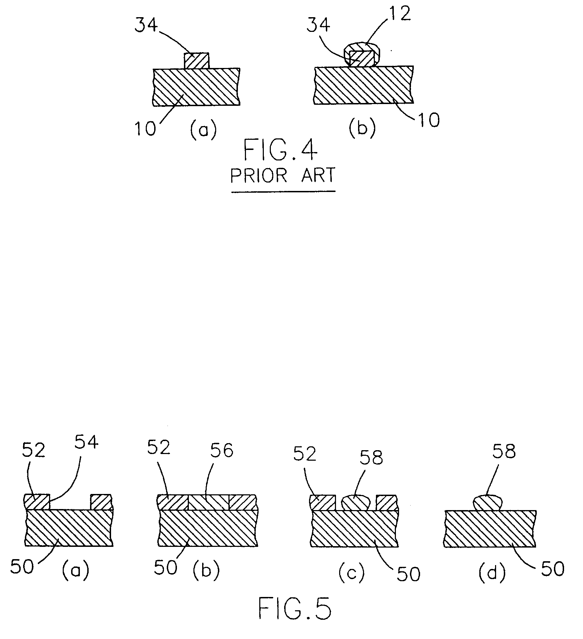

Wave soldering is another method by which solder bumps are formed in the industry. As illustrated in Figure 4(a), wave soldering involves forming a suitable substructure 34, such as a solderable contact, on the substrate 10. The use of the contact 34 when forming solder bumps with the wave solder technique is generally necessary, in that known wave soldering methods are limited to applying a relatively thin coating of solder. The contact 34 is then brought in contact with the desired solder composition, which is molten and flowing over a trough. In the process of adhering to the contact 34, the solder forms a solder bump 12, as shown at step (b).

As is known in the art, each of the above techniques has certain limitations or shortcomings, generally with respect to control of the solder bump composition, solder bump size, pitch (distance between solder bump centres), and registration, as well as processing considerations such as cost and the integrity of the substrate, its devices and the solder bumps. For the plating technique described above, the processing parameters which are likely to produce undesirable variations include the amount of surface area which is exposed by the photoresist, the current level employed, the duration of the process, and the bath chemistry. In particular, the solder composition is dependent on the plating chemistry and the degree of control over the plating current wave shape. Similarly, when employing the evaporation technique, the composition of the solder is determined by the ratio of power directed to the heating of the various metals which are the sources for the metal vapour. Typically, neither of these approaches can achieve compositional control comparable to that realised when using the predetermined solder compositions employed with the stencil printing and wave soldering techniques.

However, the stencil printing process also has its particular disadvantages. Specifically, typical limiting parameters include how thick the stencil can be made, which limits how much paste can be deposited, and how close the vias in the stencil can be located, which limits the density of the solder bumps. For example, current stencil printing techniques cannot employ vias which are spaced closer than about 0.4 millimetres between centres, in that closer spacing would require reducing the size of the vias, which in turn would undesirably limit the volume of solder which could be printed. Shadow masks used in the evaporation process appear to have similar restrictions on the size and spacing of their vias.

Some of the above techniques also have shortcomings in terms of the ability to place solder bumps accurately on the substrate in order to achieve proper registration with the conductor pattern on the circuit board. While plating techniques can achieve a registration of about ±5 micrometres, stencil techniques are generally limited to about ±50 micrometres. Registration achievable by the evaporation technique can be compromised by the ability to align the mask accurately, and then to clamp the mask so as to maintain its position during the entire evaporation cycle. The potential for misregistration arises as the temperature increases during the process due to thermal mismatch between the mask and the substrate.

Additional considerations include processing costs, which can be relatively high when using the evaporation technique, and the integrity of the substrate, its devices and the solder bumps, which can be degraded due to the thermal shock associated with the wave solder technique.

The present invention seeks to provide an improved method of forming solder bumps on a flip chip.

According to an aspect of the present invention, there is provided a method of forming solder bumps on an integrated circuit flip chip as specified in claim 1.

With regard to the continuing efforts to reduce the use of chemicals which are hazardous to the environment, a preferred embodiment seeks to eliminate the use of chemicals and processes which produce and/or release chlorofluorocarbons (CFCs) into the atmosphere. In particular, CFCs have typically been present in conventional photoresists and are likely to be released when applying or removing the photoresist used in conventional plating techniques. Additional sources of chemicals which are hazardous to the environment include the plating baths typically used in conventional electroplating processes, and the cleaning solutions typically used in wave soldering processes.

The solder bumps can provide terminals which correspond to a conductor pattern formed on a surface to which the flip chip is to be mounted.

The method can make possible the accurate location and close spacing of solder bumps on the surface of the flip chip.

Preferably, a preformulated solder paste is used so as to enable accurate control of the solder composition.

In a preferred embodiment, there is provided a method of forming solder bumps on a substrate, by which terminals for an integrated circuit flip chip are formed. The method of this embodiment relies on the use of a patterned photoresist during the deposition of the solder composition, which enables the solder composition to be accurately located on the substrate, as well as providing for minimal spacing between solder bumps. Compositional control of the solder bumps is possible in that a predetermined solder paste can be formulated prior to the deposition process, and then applied to the surface of the flip chip through the photoresist pattern. Although the method of this embodiment relies on photoresist processing, the method avoids the use of CFC-containing materials, such as those photoresist films typically used to form solder bumps with the electroplating techniques of the prior art.

Preferably, the method entails applying a suitably thick photoresist film to the substrate, and then forming the appropriate pattern in the photoresist film so as to expose those locations on the substrate at which a solder bump is to be formed, as required by the conductor pattern to which the integrated circuit flip chip is to be bonded. The solder, whose composition is established prior to the deposition step, is then applied through the photoresist pattern and onto the exposed regions of the integrated circuit flip chip. The solder is subsequently heated so as to form the desired solder bumps, and the photoresist is then stripped with a suitable solvent.

From the above, it can be seen that the preferred method can control the size and placement of the solder composition by relying on a photoresist process to locate the solder, as well as controlling the amount of solder deposited on the integrated circuit flip chip. The accuracy made possible by the photoengraving technique permits accurate placement of the solder, while the thickness of the photoresist is such that the solder can be deposited with a printer, in a manner similar to that used with stencil printing techniques. The amount of solder composition deposited is controlled by the thickness of the photoresist and the size of the opening formed in the photoresist through which the solder composition is applied. Furthermore, compositional control can be achieved by avoiding the process variants associated with plating and evaporation techniques. Since the solder composition is established prior to the deposition process, the composition of the solder is not subject to process variations during the deposition process, as is the case with plating and evaporation techniques used in the prior art. After the solder has been deposited, known solder reflow techniques can be used to form the solder bumps in a substantially conventional manner.

In addition, the use of CFC-producing compounds is notably absent from the processing steps of this invention. The use of such a photoresist is unconventional to known processes utilising solder paste to form the terminals of integrated circuit flip chips.

The method preferably encompasses the use of a photoresist which can be selectively patterned on the underlying substrate with known photoengraving techniques, through which a preformulated solder composition can be accurately and selectively deposited on the surface of the flip chip. In particular, the method preferably utilises a dry film photoresist as a mask to apply a solder paste, such that precise registration, fine pitch bump arrays and precise bump size control are possible. Precise control of the solder bump composition is also possible.

As is known in the art, integrated circuit flip chips are typically soldered to a conductor pattern which is formed on a suitable circuit board, such as a ceramic substrate or a printed wiring board. Typically, the solder composition used is a paste composed of a tin-lead solder, such as 63/37 tin-lead alloy and a binder, such as a rosin-based flux compound available under the name SP-244 from Kester Company, of Des Plaines, Illinois. The solder bumps formed on a flip chip should be arranged such that they form a pattern which is complimentary to the conductor pattern formed on the circuit board, and such that each solder bump will appropriately mate with a corresponding conductor of the conductor pattern. A typical width for a conductor is about 0.1 to about 0.3 millimetres, and a typical spacing between conductors is about 0.2 to about 0.5 millimetres between centres. While actual dimensions for a given conductor pattern may vary widely depending on the particular application, the above dimensions are indicative of the tight conductor patterns used in the industry, which require accurate control of the size and location of the solder bumps on the flip chip.

Consequently, the relatively small dimensions of and spacing between the individual solder bumps on a flip chip necessitate an extremely intricate solder deposition process. Specifically, the deposition process should ensure that each solder bump is provided with a sufficient amount of an electrically conductive solder so as to form a reliable conduction path. Simultaneously, a minimal amount of solder should be used so as to avoid creating an inadvertent electrical short between adjacent pairs of solder bumps or conductors. To afford such control, the solder should be precisely deposited in terms of the amount of solder as well as the location of the solder on the flip chip.

In the preferred embodiment of this invention, precise control of the solder composition and location of solder bumps on the flip chip are achieved through the use of a photoengraving technique which uses a dry film photoresist. The precision by which the photoresist can be patterned using photoengraving techniques provides for highly accurate placement of the solder compound on the flip chip, while the quantity of solder can be closely controlled by the thickness of the dry film photoresist used. While electroplating techniques of the prior art also use a thin photoresist film to create solder bump patterns, the preferred method is contrary to those methods, in that the solder composition and the amount of solder deposited are not dependent on the various plating parameters. Instead, the preferred method relies on a printing technique which uses a preformulated solder composition which can be selectively deposited in precisely controlled amounts.

An embodiment of the present invention is described below, by way of example only, with reference to the accompanying drawings, in which:
Figures 1 to 4 represent processing steps associated with electroplating, evaporation, stencil printing and wave soldering techniques, respectively, utilised in the prior art to form solder bumps on integrated circuit flip chips; and
Figure 5 represents the processing steps of an embodiment for forming solder bumps on an integrated circuit flip chip.

The skilled reader will understand that any layer size or range of sizes given in the ensuing description is approximate and could be changed or expanded while retaining its characteristics.

The deposition process of the preferred embodiment generally begins with the preparation of a substrate 50 on which an appropriate number of solder bumps are to be formed. Generally, the substrate 50 is cleaned such that its surface is substantially free of organic contaminants and water, for example by a method known to those skilled in the art and therefore not discussed herein.

A dry film photoresist layer 52 is then laminated onto the substrate 50. The amount of solder required determines to some degree the required thickness of the photoresist 52. In practice, a thickness of between about 0.05 and about 0.1 millimetres has been found to be suitable for producing solder bumps spaced apart about 0.2 millimetres on the substrate 50, with a thickness of about 0.1 millimetres appearing to be preferred. However, those skilled in the art will recognise that the required thickness of the photoresist 52 will vary with the particular requirements of a given application. In particular, the required thickness of the photoresist 52 is generally dictated by the required volume of solder paste for each solder bump and the size of the openings formed in the photoresist, each of which may vary from one application to another.

A preferred dry film photoresist 52 for these purposes is available under the name Laminar LP from Dynachem Electronic Materials, a division of Morton International of Tustin, California. In contrast to photoresist materials employed with prior art plating techniques to form solder bumps, this photoresist material is CFC-free and does not require conventional solvents for its photoengraving and removal. The general composition of this photoresist material includes about 25 to about 45 weight percent of high-boiling acrylic monomers/oligamers, less than about 1 weight percent tetramethyldiaminobenzophenone (Michler's ketone), and about 55 to about 75 weight percent colorants, photoinitiators and non-hazardous fillers. Presently, Laminar LP is available in sheet thicknesses of about 50 micrometres, necessitating that two layers of this photoresist be used to attain the preferred 0.1 millimetre thickness. It is to be noted that although this is the preferred material, it is foreseeable that other suitable materials could also be used.

Lamination of the photoresist 52 to the substrate 50 generally involves the use of a hot roll laminator of a type known in the art. Generally, the photoresist 52 is fed from a roller through a pair of heated rollers, where the photoresist 52 meets and is bonded to the substrate 50, which is carried to and through the heated rollers on a mylar film. The heated rollers apply sufficient pressure to the photoresist 52 and substrate 50 such that the photoresist 52 is laminated to the substrate 50 using both heat and pressure. Preferably, the heated roller that presses directly against the photoresist 52 is at a temperature of about 100°C, while the opposing heated roller which presses against the substrate 50 is at a temperature of about 90°C. As will be apparent, numerous modifications as well as alternative methods could be employed to accomplish the same result.

After lamination, the photoresist 52 can be patterned using known photolithographic techniques to form a number of suitably sized vias 54, one of which is illustrated in Figure 5, Step (a). As an example, for mating with conductors having a width of about 0.18 millimetres and spaced about 0.38 millimetres apart centre-to-centre, a via 54 having a diameter of approximately 0.3 millimetres and passing through about a 0.1 millimetre thick photoresist 52 is suitable for depositing a sufficient quantity of solder paste. The preferred photoresist 52 is then exposed to ultraviolet light through a photomask (not shown) in a conventional contact mask aligner of the type used in wafer fabrication. Alignment can be achieved by looking at the photomask and substrate 50 through a microscope, after which the photomask and substrate 50 are put in contact. Alignment is then reverified and the substrate 50 is exposed to the ultraviolet light without further motion of the substrate 50 or photomask. The substrate 50 is then developed on a wafer resist developer of the type known in the prior art. Development preferably involves the use of a mild caustic solution, such as an approximately 1% by volume solution of potassium carbonate (K2CO3), to remove that portion of the photoresist 52 which was not exposed to the ultraviolet light. Notably, the above alignment technique enabled by the use of the dry film photoresist 52 allows for registration between the flip chip and its solder pad pattern on the order of about ±5 micrometres, which is significantly better than that for known stencil printing techniques and approximates that of known plating techniques.

The dry film photoresist 52 photoengraved in accordance with the above steps serves as a dedicated, photoimageable stencil pattern which is directly adhered to the substrate 50, in contrast to stencil printing techniques known in the prior art in which a stencil is repeatedly aligned but not adhered to a wafer. Solder paste 56 is then applied to the substrate 50 through the via 54 formed in the photoresist 52. Due to the thickness of the photoresist 52, known printing techniques such as that employed with screen printing can be used to deposit a quantity of solder paste through the via 54 using a squeegee. The result of this process is represented in Step (b) of Figure 5. Again, the quantity of solder paste 56 deposited is accurately controlled by the thickness of the photoresist 52 and the size of the via 54 in the photoresist 52. Due to this degree of control and the precise size and spacing enabled by the described method, it has been determined that sufficient solder paste 56 can be deposited onto the substrate 50 such that it is unnecessary to also deposit solder on the circuit board to achieve a reliable connection. Furthermore, because a preformulated solder paste 56 can be used with the preferred method, the solder paste 56 can be specifically formulated to be a mixture of any number of metals in any proportions, so as to achieve a high degree of control over the composition of the solder paste 56, generally on the order of within about ±0.1 weight percent, and accordingly a high degree of control over the characteristics of the solder.

A solder reflow process of a type known to the art is then used to transform the mass of solder paste 56 deposited within the via 54 to a solder bump 58, as shown in Step (c) of Figure 5. The solder paste 56 must be sufficiently heated to volatilise the binder and melt the solder alloy, so as to form as appropriate the solder bump 58. Preferably, this step is carried out using a reflow technique which locally heats the solder paste 56 to a temperature above the melting point of the solder alloy. Using the preferred solder alloy, the solder paste is preferably heated using an automatic hot plate to a temperature of about 200°C to about 300°C for a duration of about 30 to about 60 seconds. While the above reflow cycle has been found to achieve suitable results, those skilled in the art will recognise that a preferred temperature cycle for a given application will depend at least in part on the size of the substrate 50 and the amount of solder paste 56 deposited on the substrate 50, as well as other factors. Thus, the actual temperatures and durations employed during the reflow process may vary significantly from those provided above. In addition, those skilled in the art will recognise that other heating methods could be employed to achieve similar results.

Once the solder bump 58 has resolidified, the photoresist 52 is stripped from the substrate 50 using a conventional solvent, such as Uresolve SG available from Dynaloy of Hanover, New Jersey, to produce the results shown in Step (d) of Figure 5. The flip chip can then be brought into position over its conductor pattern, aligned using known techniques, and mated such that the solder bumps 58 mate precisely with the conductors of the conductor pattern. Heat is again applied so as to reflow the solder bumps 58 and metallurgically bond the individual solder bumps 58 to their respective conductors.

From the above, it can be seen that the composition of the solder bumps 58 is determined by the composition of the solder paste 56. The solder paste 56 can be made with a mixture of any number of metals in any proportions, to controlled compositions within about ±0.1 weight percent. In contrast, solder compositions produced by prior art plating techniques are dependent on the plating chemistry and, in particular when alloy plating, density depends on the control of the plating current wave shape. Furthermore, with evaporation techniques of the prior art, the solder composition is determined by the ratio of power directed to the various metals being heated as the sources. Typically, such methods cannot be controlled as well, as compared to the blending of a solder paste composition.

In addition, because a dry film photoresist is used, spacing of less than about 0.4 millimetres between vias, and therefore solder bump centres, can be readily achieved, with a spacing of as little as about 0.2 millimetres or less being possible. Current stencil techniques typically cannot achieve spacing between solder bumps of less than about 0.4 millimetre without resulting in an insufficient volume of solder paste being deposited. It is also believed that metal masks used in known evaporation techniques are also incapable of achieving the solder bump spacing realised by the described method.

The alignment technique enabled by the use of the dry film photoresist 52 allows for registration on the order of about ±5 micrometres, which approximates that of known plating techniques. Comparable registration precision using known evaporation techniques is made difficult by the requirement adequately to align, clamp and hold the metal mask in position during the entire evaporation cycle, which is complicated by a thermal mismatch which exists between the metal mask and the silicon wafer.

The disclosures in United States patent application no. 157,511, from which this application claims priority, and in the abstract accompanying this application are incorporated herein by reference.

## Claims

1. A method of forming solder bumps on an integrated circuit flip chip comprising the steps of applying a photoresist film (52) to a surface (50) of an integrated circuit flip chip; forming a pattern in the photoresist film so as to expose portions (54) of the surface, the exposed portions corresponding to locations for solder bumps of the integrated circuit flip chip; printing solder paste through the pattern onto the surface at the exposed portions; heating the solder paste so as to form the solder bumps (58); and stripping the photoresist film from the surface.

2. A method according to claim 1, wherein the solder bumps (58) form terminals for the integrated circuit flip chip.

3. A method according to claim 1 or 2, wherein the photoresist film (52) is a CFC-free dry film photoresist.

4. A method according to claim 3, wherein the dry film photoresist is a negative ultraviolet light-sensitive dry film photoresist.

5. A method according to claim 3 or 4, wherein the dry film photoresist comprises 25 to 45 weight percent of high-boiling acrylic monomers/oligamers, less than 1 weight percent tetramethyldiaminobenzophenone, and 55 to 75 weight percent colorants, photoinitiators and non-hazardous fillers.

6. A method according to claim 3, 4 or 5, wherein the dry film photoresist is laminated to the substrate.

7. A method according to any one of claims 3 to 6, wherein a plurality of dry film photoresist layers are applied to the substrate.

8. A method according to any preceding claim, wherein the photoresist film has a thickness of 0.05 to 0.1 millimetres.

9. A method according to any preceding claim, including the step of spacing the exposed portions of surface in the pattern such that adjacent quantities of solder paste are deposited less than substantially 0.4 millimetres apart centre-to-centre.

10. A method according to claim 9, wherein the spacing between centres of the adjacent quantities of solder paste is as little as substantially 0.2 millimetres.

11. A method according to any preceding claim, wherein the pattern is photoengraved into the photoresist film.

12. A method according to any preceding claim, comprising the step of formulating the solder paste to comprise a mixture of metals, the proportions of metals within the mixture being controlled to be within substantially ±0.1 weight percent.
